# EUROPEAN PATENT APPLICATION

(11) **EP 4 693 254 A1**
(43) Date of publication of application: **11.02.2026**
(21) Application number: 25193615.9
(22) Date of filing: 04.08.2025
(51) Int. Cl.: G08G 5/21, G08G 5/22, G08G 5/26, G08G 5/32, G08G 5/34, G08G 5/53, G08G 5/55, G08G 5/76

(54) **SYSTEM AND METHOD FOR DETERMINING A FLIGHT PATH FOR AN AIRCRAFT**

(30) Priority: 05.08.2024 US 202418794098
(71) Applicant: The Boeing Company, Arlington, VA 22202 (US)
(72) Inventor: NARASIMHULU, Veeresh Kumar Masaru, SAMMAMISH (US); KOENNEN, Joost Edwin, MEPPEL (NL)
(74) Representative: Plasseraud IP

(57) **Abstract**

A system (100) and a method include an aircraft (102) including a user interface (112) having a display (114). A control unit (110) is in communication with the user interface (112). The control unit (110) is configured to determine a flight path (200) for a flight of the aircraft (102) based on tail-specific data (122) for the aircraft (102), and weather conditions.

## Description

### FIELD OF THE DISCLOSURE

Examples of the present disclosure generally relate to systems and methods for determining a flight path for an aircraft, and, more particularly, to determining an optimized flight path for an aircraft.

### BACKGROUND OF THE DISCLOSURE

Aircraft are used to transport passengers and cargo between various locations. Numerous aircraft depart from and arrive at a typical airport every day.

A lateral flight path (that is, a lateral and longitudinal path between locations) for an aircraft is determined by a flight planner, who typically looks at possible route options and constructs a route to fly from a departure airport to a destination airport. A flight path is typically based on existing restrictions (such as closed airspace), and generic performance data of an aircraft. The flight path can be a most fuel-efficient or cost-efficient route available, and based on assumptions about weather, weights, performance, and an assumed fuel mileage. Each flight path is filed (such as with air traffic control), and typically not adjusted over time.

During a flight, pilots often face multiple decisions in terms of lateral changes. For example, air traffic control can offer pilots directs, reroutes, or other changes to an original flight path. As such, pilots need to assess if such a change is a better option, and determine if the adjusted route provides any advantages (such as a cost savings in terms of fuel burn). In other words, pre-flight and in-flight dynamics may prompt changes and different options.

An air traffic controller may not know if a direct route between two different locations provides a beneficial change for a flight. In particular, an air traffic controller may not consider weather, the mission profile of the flight, and other such factors. Instead, an air traffic controller may assume that a shorter router is better. Additionally, an operational control center often does not have the time, nor the means to rerun flight plans to search for better options given changing dynamics. Finally, pilots may not have sufficient time to assess route changes, search for better lateral options, or assess an impact of a change to a flight plan. Instead, pilots may rely on a flight management computer, which can provide a very rudimentary prediction based on generic performance data.

### SUMMARY OF THE DISCLOSURE

A need exists for a system and a method for efficiently and effectively assessing a flight path, including changes to an existing flight path. Further, a need exists for a system and a method for accurately determining an optimized flight path based on specific flight data for a particular aircraft.

With those needs in mind, certain examples of the present disclosure provide a system including an aircraft having a user interface including a display. A control unit is in communication with the user interface. The control unit is configured to determine a flight path for a flight of the aircraft based on tail-specific data for the aircraft, and weather conditions.

In at least one example, the control unit is configured to determine the flight path before the flight of the aircraft. In at least one other example, the control unit is configured to determine the flight path during the flight of the aircraft.

In at least one example, the control unit is configured to determine the flight path from a machine learning model. For example, the control unit is further configured to use the machine learning model to simulate numerous possible flight paths, and determine the flight path from the numerous possible flight paths. As a further example, the control unit is further configured to load and use the machine learning model based on data from a current flight (and optionally data from past flights), current (and optionally past) weather data, and changing aspects of a state of the aircraft. In at least one example, the control unit includes an artificial neural network configured to identify the flight path.

In at least one example, the aircraft includes the control unit.

The weather conditions include current weather conditions and/or forecasted weather conditions.

The control unit can be further configured to automatically operate the aircraft according to the flight path.

The control unit is further configured to show the flight path on the display.

The control unit can be further configured to automatically select the flight path for the aircraft.

Certain examples of the present disclosure provide a method for a system including an aircraft including a user interface having a display, and a control unit in communication with the user interface. The method includes determining, by the control unit, a flight path for a flight of the aircraft based on tail-specific data for the aircraft, and weather conditions.

Certain examples of the present disclosure provide an aircraft including controls configured to operate the aircraft, a user interface having a display, and a control unit in communication with the user interface, as described herein.

### BRIEF DESCRIPTION OF THE DRAWINGS

Figure 1 illustrates a schematic block diagram of a system, according to an example of the present disclosure.
Figure 2 illustrates a front view of a display showing a flight path, according to an example of the present disclosure.
Figure 3 illustrates a flow chart of a method, according to an example of the present disclosure.
Figure 4 illustrates a schematic block diagram of a control unit, according to an example of the present disclosure.
Figure 5 illustrates a perspective front view of an aircraft, according to an example of the present disclosure.

### DETAILED DESCRIPTION OF THE DISCLOSURE

The foregoing summary, as well as the following detailed description of certain examples will be better understood when read in conjunction with the appended drawings. As used herein, an element or step recited in the singular and preceded by the word "a" or "an" should be understood as not necessarily excluding the plural of the elements or steps. Further, references to "one example" are not intended to be interpreted as excluding the existence of additional examples that also incorporate the recited features. Moreover, unless explicitly stated to the contrary, examples "comprising" or "having" an element or a plurality of elements having a particular condition can include additional elements not having that condition.

Examples of the present disclosure provide systems and methods that allow pilots to receive real time advisories based on tail specific performance for a particular aircraft. The advisories and assessments include accurate fuel and time calculations, which allow the pilots to find preferable routes, and adjust a flight trajectory based on actual, pinpoint accurate data. The systems and methods use tail-specific data for an aircraft, instead of generic performance data. Notably, calculating an impact of a change to a flight path (such as a direct or reroute) with generic data often leads to inaccuracies, which can lead to incorrect assessments, and create fuel and time losses.

The systems and methods described herein are configured to optimize a flight path for an aircraft. The systems and methods include a control unit that assesses latest weather conditions, and tail specific performance of an aircraft to determine the flight path. The number of trajectory options and randomness in weather changes can be so vast that performing a static simulation of the trajectory and evaluating all possible options can be prohibitive in terms of time taken and accuracy of calculations. In at least one example, the control unit uses a machine learning model that is built using simulated data from the multiple evaluations of all possible trajectory options, and possible weather conditions. The resulting model is loaded on a computing device (such as a flight computer, a handheld smart device, and/or the like), and used in real time with changing aircraft state and weather conditions to dynamically select the most fuel and time economical path among various options.

The systems and methods described herein optimize a flight path, and refine fuel efficiency for an aircraft by using tail-specific performance (that is, performance of the specific, actual aircraft, in contrast to a different test aircraft), which delivers precise data compared to pre-set fixed speeds generated by flight planning systems. Certain examples of the present disclosure provide systems and methods that use tail-specific data modeling combined with iterative algorithms to find the most efficient flight path between different locations (such as between a departure airport and a destination airport, or at a point within a flight path to the destination airport).

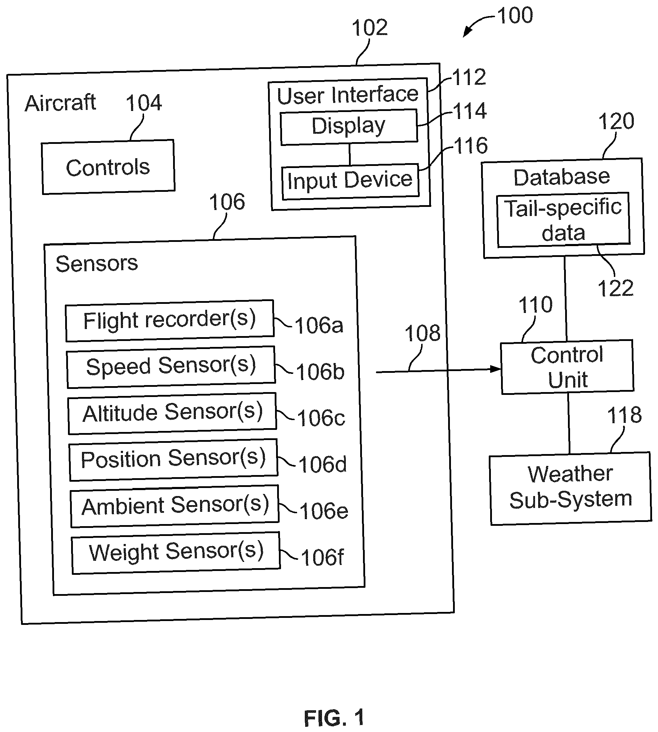

Figure 1 illustrates a schematic block diagram of a system 100, according to an example of the present disclosure. In at least one example, the system 100 is configured to determine a flight path for an aircraft 102. As an example, the flight path is between a departure airport or location and an arrival or destination airport or location. As another example, the flight path can be or otherwise include a change of an original flight path, such as direct or reroute from a point along the original flight path to the destination location.

The aircraft 102 includes controls 104 that are configured to control operation of the aircraft 102. For example, the controls 104 include one or more of a control handle, yoke, joystick, control surface controls, accelerators, decelerators, and/or the like.

The aircraft 102 further includes a plurality of sensors 106 that detect various aspects of the aircraft 102. As an example, the sensors 106 include one or more flight recorders 106a that record various aspects of the aircraft 102 during a flight, including various phases, legs of a flight path, and the like. A speed sensor 106b of the aircraft 102 outputs a speed signal indicative of a ground and/or air speed of the aircraft 102. An altitude sensor 106c of the aircraft 102 outputs an altitude signal indicative of an altitude of the aircraft 102. A position sensor 106d outputs a position signal of the aircraft. As an example, the position signal can be an automatic dependent surveillance-board (ADS-B) signal. As another example, the position signal can be a global positioning system (GPS) signal that is monitored by a corresponding GPS monitor. In at least one example, GPS allows for determination of position, and ADS-B provides a transmission system to broadcast the position, which can be determined through GPS and/or inertial sensors.

The sensors 106 can also include one or more ambient sensors 106e. For example, an ambient sensor 106e can include a temperature sensor that is configured to detect an ambient temperature surrounding the aircraft 102. As another example, an ambient sensor 106e can include a wind speed sensor.

The sensors 106 can also include one or more weight sensors 106f. For example, the weight sensors 106f can include a sensor that is configured to detect an overall weight of the aircraft. As another example, the weight sensors 106f can include a sensor that is configured to detect a fuel weight within the aircraft 102. As another example, the weight sensors 106f can include a sensor configured to determine a center of gravity of the aircraft 102.

The sensors 106 can include more or less sensors than shown. The sensors 106 can detect additional aspects of the aircraft 102 other than position, speed, and altitude. For example, one or more temperature sensors can detect temperatures of one or more portions of the aircraft (such as engine temperature sensors). As another example, fuel level sensors can detect a remaining fuel level of the aircraft.

The sensors 106 output data 108 indicative of the various aspects detected thereby. For example, the data 108 includes avionics data output by the flight recorder(s) 106a. A control unit 110 is in communication with the sensors 106 through one or more wired or wireless connections, and is configured to receive the data 108 from the sensors 106.

In at least one example, the control unit 110 is onboard the aircraft 102. For example, the control unit 110 can be part of the flight management computer of the aircraft 102. As another example, the control unit 110 can be part of a handheld device (such as a smart phone or smart tablet), a portable computer, a computer workstation, and/or the like within the aircraft 102. As another example, the control unit 110 can be remote from the aircraft 102.

The aircraft 102 also includes a user interface 112, which includes a display 114 in communication with an input device 116. The display 114 can be a monitor, screen, television, touchscreen, and/or the like. The input device 116 can include a keyboard, mouse, stylus, touchscreen interface (that is, the input device 116 can be integral with the display 114), and/or the like. The user interface 112 can be part of a handheld device (such as a smart phone or smart tablet), a portable computer, a computer workstation, and/or the like within the aircraft 102. In at least one example, the control unit 110 and the user interface 112 are part of a common computing device.

The control unit 110 is also in communication with a weather sub-system 118, such as through one or more wired or wireless connections. The weather sub-system 118 can be a weather forecasting or meteorological service. As another example, the weather sub-system 118 can provide information, such as through Aircraft Communications Addressing and Reporting System (ACARS) messages. ACARS is a digital datalink system which transmits short messages between aircraft and ground stations, such as through radio signals or satellites. The control unit 110 and the weather sub-system 118 can be at different locations. Optionally, the control unit 110 and the weather sub-system 118 can be at a common location.

The control unit 110 is also in communication with a database 120 that stores tail-specific data 122 for the aircraft 102. For example, the tail-specific data 122 can include various types of information specific to the particular aircraft 102, as opposed to a general set of data for a particular type of aircraft. In at least one example, the tail-specific data 122 can be a tail-specific model for the particular aircraft 102.

In operation, the control unit 110 analyzes weather data from the weather sub-system 118, the tail-specific data 122 and/or the data 108 to determine one or more flight paths for the aircraft 102, in order for the aircraft 102 to efficiently and economically operate the aircraft 102. In at least one example, the control unit 110 analyzes such data before a flight of the aircraft to determine an efficient flight path for the aircraft 102. As another example, the control unit 110 analyzes such data during a flight of the aircraft to determine an efficient change to the flight path. Instead of relying on a generic determination for flight parameters, the control unit 110 determines flight parameters or attributes (such as airspeed and altitude) for the aircraft based on actual data 108 output by the sensors 106 of the aircraft 102 during one or more actual flights of the aircraft 102. For example, the control unit 110 can determine efficient flight parameters for a future flight of the aircraft 102 based on the data 108 from one or more previous flights. In at least one example, the control unit 110 determines the flight parameters for a future flight based on the data 108 received from an immediately prior flight of the aircraft 102. As another example, the control unit 110 determines the flight parameters for the future flight of the aircraft based on the data 108 from a plurality of previous flights, such as the most recent 10, 20, 30, 40, or more flights of the aircraft 102. In this manner, the additional data from a plurality of flights of the aircraft 102 provides a more robust and refined determination of the flight parameters.

In at least one example, the control unit 110 determines the efficient flight parameters to determine a flight path for a current or future flight of the aircraft 102 by generating one or more flight models for the aircraft 102 based on the data 108 received from the actual aircraft 102 (that is, the specific tail associated with the aircraft 102), instead of a different aircraft or generic model.

In operation, the sensors 106 detect various aspects of the aircraft 102 during a flight. The sensors 106 output the data 108 indicative of the various aspects of the aircraft 102. The control unit 110 receives the data 108 for the particular aircraft 102 (as opposed to a test or generic aircraft). In at least one example, the flight recorder(s) 106a includes an aircraft interface device and transmitter that outputs the data 108, such as avionics data, to the control unit 110. As noted, the control unit 110 is in communication with the flight recorder(s) 106a through one or more wired or wireless connections, such as through WiFi, Bluetooth, cellular, or other such connections. After the flight of the aircraft 102, the data 108 can be stored, such as in cloud servers, which can be used to perform post-flight analytics to estimate savings, further fine tune performance models, and/or the like.

In at least one example, the control unit 110 generates an optimized flight path based on the tail-specific data of the aircraft 102, and current and/or predicted weather at various locations, as received from the weather sub-system 118. The control unit 110 increases fuel efficiency by using tail-specific performance, which increases precision as compared to generic data generated by flight planning systems.

In at least one example, for each aircraft 102 (that is, a tail) the control unit 110 uses actual flight recordings to build tail-specific deep neural network models, estimate airspeed, fuel flow, altitude, and the like during the various legs of a flight path. For a given flight condition, the control unit 110 iterates over a range of cost index (such as based on a predetermined inflight descent table) to determine an optimum flight path for the aircraft 102.

In at least one example, the control unit 110 automatically operates one or more controls 104 of the aircraft 102 during a flight to automatically operate the aircraft 102 according to the determined flight path. For example, the control unit 110 determines various trajectories, airspeeds, and altitudes for different legs of a flight path of an aircraft 102. The control unit 110 automatically operates the controls 104 to ensure that the aircraft 102 operates according to the determined flight path. Optionally, the control unit 110 may not automatically operate the aircraft 102.

The control unit 110 uses the tail-specific performance data of the aircraft 102 (in contrast to generic performance data) to determine an efficient flight path between locations. In contrast, prior known methods use a generic database and do not account for tail specific differences in performance, which can otherwise lead to inefficiencies.

In at least one example, the control unit 110 is a machine learning system, which simulates numerous possible flight paths to ultimately determine a most efficient flight path for the aircraft 102. For example, the control unit 110 assesses possible flight paths, and possible weather conditions along such flight paths However, evaluating all possible trajectory options with all possible operating conditions can be computationally expensive and time-consuming. Also, weather conditions can change rapidly. Accordingly, the control unit 110 builds a machine learning model based on a ground-based simulation, and evaluates all possible options and subsequent evaluations one time before any flights. Because the control unit 110 predetermines all possible options (including weather conditions, flight trajectories, and tail-specific performance data for the aircraft), prior to an actual flight (or during the flight), the control unit 110 'can then assess the current weather conditions, flight data of the aircraft 102 (as detected by the sensors 106) and quickly and efficiently select a match among the predetermined options for flight paths, and accordingly select the most efficient flight path for the aircraft 102. The control unit 110 can then output a signal to the user interface 112, and electronically show the determined flight path on the display 114. As such, the control unit 110 predetermines a machine learning model for flight paths including possible weather conditions (including wind directions and wind speeds), and then selects a most efficient, optimized flight path for the aircraft 102 according to current weather conditions, and tail specific data of the aircraft 102.

In at least one example, the control unit 110 is configured to intelligently select a flight path from a plurality of predetermined flight paths and route options. As an example, for each waypoint along a flight path, the control unit 110 selects N nearest waypoints as candidate next waypoints within a specified threshold of track angles. In doing so, the control unit 110 improves a computing device by limiting the number of evaluation options by only considering relevant segments (and thereby reducing power consumption and computing time).

The control unit 110 receives weather data from the weather sub-system 118. The weather data includes past historical weather for various locations, as well as forecasted weather for such location. The control unit 110 merges the forecasted weather with historical weather to determine limits for trajectory evaluation, which also improves a computing device by limiting the number of evaluation options by only considering relevant weather conditions (and thereby reducing power consumption and computing time).

In at least one example, the control unit 110 uses the machine learning model to evaluate any combination of lateral path changes. The control unit 110 can further update, load, and/or use the machine learning model based on flight path data from a current flight (and optionally flight path data from past flights), current (and optionally past) weather data, changing aspects of a state of the specific aircraft 102 as determined from the sensors 106, and the like. That is, while the control unit 110 generates the machine learning model, the control unit 110 may continually refine the machine learning model. In at least one example, the machine learning model is updated before a flight, and then used by the control unit 110 during the flight. The machine learning model can be periodically updated, such as after a predetermined number of flights, or a predetermined time period (such as a week, a month, or the like).

In at least one example, the machine learning model includes a tail-specific fuel flow model. The tail-specific fuel flow model is a model regarding fuel flow for a particular aircraft (as opposed to generic fuel data). The tail-specific fuel flow model can be periodically updated, such as every month, two months, or the like. In at least one further example, the machine learning model also includes a flight-specific trajectory model, which relates to a specific trajectory for an actual flight (as opposed to generic flight data). The flight-specific trajectory model can be built and updated for each flight of the aircraft 102, and deleted after each flight.

As described, the control unit 110 receives weather data from the weather sub-system 118, specific performance data for the actual aircraft 102 from the tail-specific data 122 and/or data received from the sensors 106, and uses the machine learning model to simulate various flight paths. The control unit 110 assess the current weather conditions (as received in data from the weather sub-system 118) to match weather conditions of a simulated flight path for the specific aircraft (that is, the tail-specific data for the aircraft 102) within the machine learning model. The control unit 110 selects the flight path within the machine learning model that conforms to (for example, matches or is a closest match) the current weather conditions for locations, and the tail-specific data of the aircraft 102.

In at least one example, the system 100 includes the aircraft 102, which includes the user interface 112 having the display 114. The control unit 110 is in communication with the aircraft 102. The control unit is configured to determine one or more flight paths for a flight of the aircraft 102 based on the tail-specific data122 for the aircraft 102, and weather conditions (such as at various locations along the flight path(s)). In at least one example, the control unit 110 is configured to determine the one or more flight paths before the flight of the aircraft 102. As another example, the control unit 110 is configured to determine the one or more flight paths during the flight of the aircraft 102.

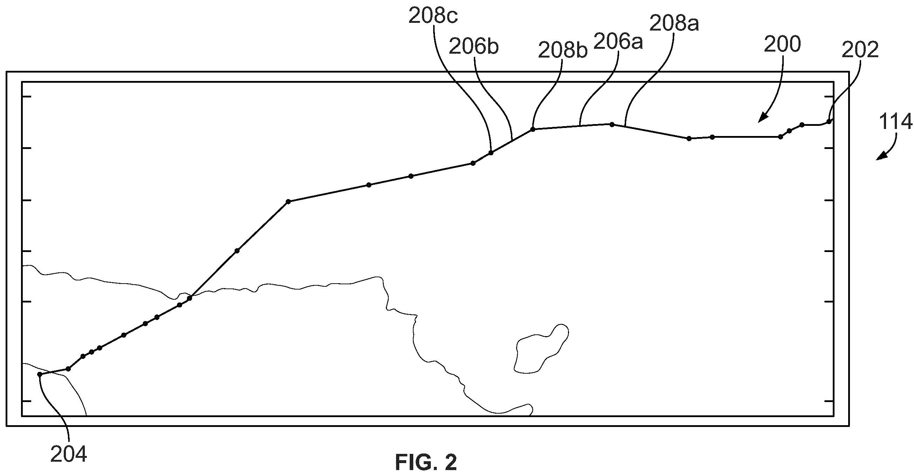

Figure 2 illustrates a front view of the display 114 showing a flight path 200, according to an example of the present disclosure. The flight path 200 includes a departure airport 202 and an arrival airport 204. Various legs exist between the departure airport 202 and the arrival airport 204. For example, a first leg 206a is between a first waypoint 208a and a second waypoint 208b. A second leg 206b is between the second waypoint 208b and a third waypoint 208c. Referring to Figures 1 and 2, the control unit 110 determines the flight path between the departure airport 202 and the arrival airport 204 before the actual flight of the aircraft 102. As another example, the control unit 110 determines the flight path between different points (such as between different waypoints, or between a waypoint and the arrival airport 204) during a flight of the aircraft. That is, the control unit 110 determines a change to the flight path during flight.

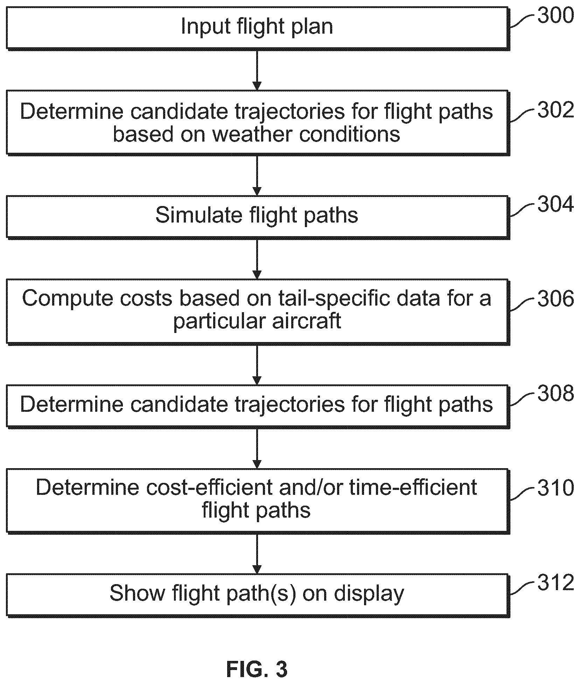

Figure 3 illustrates a flow chart of a method, according to an example of the present disclosure. Referring to Figures 1 and 3, at 300, a flight plan is input. The flight plan is or includes an initial flight path between locations. The flight plan can be input through the user interface 112, which can be onboard the aircraft 102, or remotely located from the aircraft 102 (such as an at operational control center). The control unit 110 receives the flight plan from the user interface 112, such as via one or more electronic signals that include data.

At 302, after receiving the flight plan, the control unit 110 determines candidate trajectories for flight paths based on weather conditions. The weather conditions are current weather conditions and/or forecasted weather conditions for various locations along flight paths, as received from the weather sub-system 118 (such as via one or more electronic signals that include data).

At 304, the control unit 110 simulates flight paths for the flight paths. The control unit 110 simulates the flight paths from a machine learning model, which predetermines the flight paths for the weather conditions and the tail-specific data of the aircraft 102. The control unit 110 can update. Load, and/or use the machine learning model based on current and forecasted weather conditions, flight restrictions (such as restricted airspaces), current flight data for the specific aircraft 102 as detected by the sensors 106, and/or the like.

Based on the current weather conditions, the control unit 110 can eliminate various flight paths within the machine learning model that do not conform to the current and/or forecasted weather conditions. Further, based on current tail-specific data for the aircraft, the control unit 110 can eliminate various flight paths that do not conform to the current operational capabilities of the aircraft 102.

After determining the possible flight paths, the control unit 110 then computes costs for the flight paths based on the tail-specific data of the aircraft 102. The control unit 110 can then eliminate flight paths that exceed a predetermined cost threshold, such as in term of fuel burn, and/or are too long. At 308, the control unit 110 determines candidate trajectories for the flight path(s). At 310, the control unit determines the most cost-efficient, and/or time-efficient flight path(s). At 312, the control unit 110 then electronically shows the determined flight path(s) on the display 114 (for example, the control unit 110 outputs an electronic signal having data that includes the determined flight path(s), and operates the display 114 to show the determined flight path(s)).

A pilot can then select the flight path(s). As another example, the control unit 110 automatically selects the flight path, such as via inputs received via the input device 116. For example, a pilot can provide via the input device 116 an instruction to select the most fuel-efficient flight path, or the quickest flight path to a destination. The control unit 110 receives the instruction, and automatically selects the flight path according to such instruction.

In at least one example, the control unit 110 can operate the controls of the aircraft to automatically operate the aircraft according to the flight path. As an example, the flight path can provide an input for an auto-pilot mode of operation.

As described herein, the control unit 110 uses the tail-specific data 122 for the aircraft 102 (instead of generic data), along with weather conditions (for example, current and/or forecasted weather at various locations) to determine the flight path for the aircraft 102. The control unit 110 determines the flight path before a flight of the aircraft 102, and/or during a flight of the aircraft (such as a change to an initial flight path during the flight).

In at least one example, the control unit 110 adapts the flight path based on current and predicted/forecasted weather conditions, such as wind direction and wind speed at various legs, instead of using weather info that is not current. The control unit 110 receives information regarding the latest winds, thereby ensuring efficient adaptation of a flight path.

The systems and methods described herein allow a pilot to fly the aircraft 102 along optimal flight paths, which save considerable amounts of fuel.

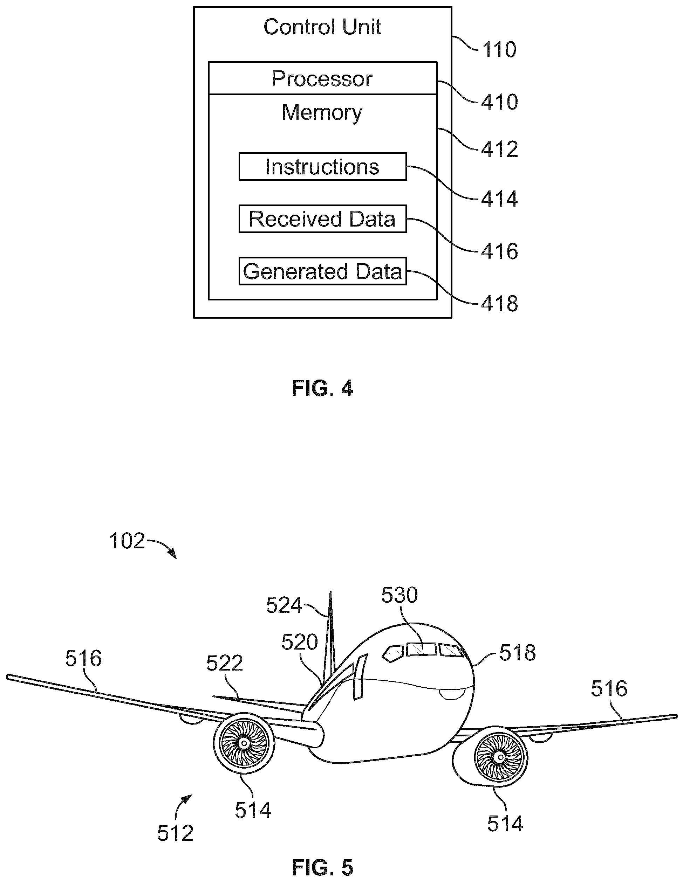

Figure 4 illustrates a schematic block diagram of the control unit 110, according to an example of the present disclosure. In at least one example, the control unit 110 includes at least one processor 410 in communication with a memory 412. The memory 412 stores instructions 414, received data 416, and generated data 418. The control unit 110 shown in Figure 4 is merely exemplary, and non-limiting.

As used herein, the term "control unit," "central processing unit," "CPU," "computer," or the like may include any processor-based or microprocessor-based system including systems using microcontrollers, reduced instruction set computers (RISC), application specific integrated circuits (ASICs), logic circuits, and any other circuit or processor including hardware, software, or a combination thereof capable of executing the functions described herein. Such are exemplary only, and are thus not intended to limit in any way the definition and/or meaning of such terms. For example, the control unit 110 may be or include one or more processors that are configured to control operation, as described herein.

The control unit 110 is configured to execute a set of instructions that are stored in one or more data storage units or elements (such as one or more memories), in order to process data. For example, the control unit 110 may include or be coupled to one or more memories. The data storage units may also store data or other information as desired or needed. The data storage units may be in the form of an information source or a physical memory element within a processing machine.

The set of instructions may include various commands that instruct the control unit 110 as a processing machine to perform specific operations such as the methods and processes of the various examples of the subject matter described herein. The set of instructions may be in the form of a software program. The software may be in various forms such as system software or application software. Further, the software may be in the form of a collection of separate programs, a program subset within a larger program, or a portion of a program. The software may also include modular programming in the form of object-oriented programming. The processing of input data by the processing machine may be in response to user commands, or in response to results of previous processing, or in response to a request made by another processing machine.

The diagrams of examples herein may illustrate one or more control or processing units, such as the control unit 110. It is to be understood that the processing or control units may represent circuits, circuitry, or portions thereof that may be implemented as hardware with associated instructions (e.g., software stored on a tangible and non-transitory computer readable storage medium, such as a computer hard drive, ROM, RAM, or the like) that perform the operations described herein. The hardware may include state machine circuitry hardwired to perform the functions described herein. Optionally, the hardware may include electronic circuits that include and/or are connected to one or more logic-based devices, such as microprocessors, processors, controllers, or the like. Optionally, the control unit 110 may represent processing circuitry such as one or more of a field programmable gate array (FPGA), application specific integrated circuit (ASIC), microprocessor(s), and/or the like. The circuits in various examples may be configured to execute one or more algorithms to perform functions described herein. The one or more algorithms may include aspects of examples disclosed herein, whether or not expressly identified in a flowchart or a method.

As used herein, the terms "software" and "firmware" are interchangeable, and include any computer program stored in a data storage unit (for example, one or more memories) for execution by a computer, including RAM memory, ROM memory, EPROM memory, EEPROM memory, and non-volatile RAM (NVRAM) memory. The above data storage unit types are exemplary only, and are thus not limiting as to the types of memory usable for storage of a computer program.

In at least one example, the control unit 110 can further control, at least in part, the controls 104 of the aircraft 102 to operate the aircraft 102 based on the determined flight path. For example, based on the determined flight path, the control unit 110 can automatically operate the controls 104 to increase or decrease ground or airspeed, rate of climb, and the like of the aircraft 102.

In at least one example, all or part of the systems and methods described herein may be or otherwise include an artificial intelligence (AI) or machine-learning system that can automatically perform the operations of the methods also described herein. For example, the control unit 110 can be an artificial intelligence or machine learning system. These types of systems may be trained from outside information and/or self-trained to repeatedly improve the accuracy with how data is analyzed to determine flight paths between different locations, as well as adapt parameters based on tail-specific data 122 and weather conditions. Over time, these systems can improve by determining flight path parameters with increasing accuracy and speed, thereby significantly reducing the likelihood of any potential errors. The AI or machine-learning systems described herein may include technologies enabled by adaptive predictive power and that exhibit at least some degree of autonomous learning to automate and/or enhance pattern detection (for example, recognizing irregularities or regularities in data), customization (for example, generating or modifying rules to optimize record matching), or the like. The systems may be trained and re-trained using feedback from one or more prior analyses of the data, ensemble data, and/or other such data. Based on this feedback, the systems may be trained by adjusting one or more parameters, weights, rules, criteria, or the like, used in the analysis of the same. This process can be performed using the data and ensemble data instead of training data, and may be repeated many times to repeatedly improve the determination of flight paths. The training minimizes conflicts and interference by performing an iterative training algorithm, in which the systems are retrained with an updated set of data (for example, data 108 received during and/or after each flight of the aircraft 102) and based on the feedback examined prior to the most recent training of the systems. This provides a robust analysis model that can better determine the most cost effective and efficient flight paths for the specific aircraft 102.

In at least one example, the control unit 110 includes or represents an artificial neural network (ANN) that identifies patterns in the visual representations of data, classifies the patterns (for example, assigns a class to an identified pattern, such as class #1, class #2, and so on) based on the contents of the patterns that are identified, and identifies one or more flight paths based on the classifications. Usage of a specially trained ANN to identify flight paths in this way provides improvements over traditional methods of determining a flight path, including more accurate identification of efficient flight paths, and identification various types of flight paths on a much larger scale than is possible with humans determining flight paths, and identification of the flight paths much faster and/or at a much more rapid frequency than is possible with humans. The ANN can be realized through software, hardware, or a combination of software and hardware. The structure of the ANN can be a series of layers, with each layer including one or more artificial neurons arranged in one or more neuron arrays. Each of these neurons may include or represent a register, a microprocessor, and at least one input. Each neuron can produce an output, or activation, based on an activation function that uses the outputs of the previous layer and a set of weights as inputs. Each neuron in a neuron array can be connected to another neuron in the same layer or in another layer via one or more synaptic circuits. A synaptic circuit may include a memory for storing a synaptic weight. One example of this ANN may be a deep neural network having an input layer, an output layer, and a plurality of fully connected hidden layers. In some examples, the ANN (e.g., the control unit 110) can be implemented by an application-specific integrated circuit (ASIC) specially customized for the specific artificial intelligence application described herein and provide superior computing capabilities and reduced electricity consumption compared to traditional computers.

Training data can be generated by receiving continuous data at the control unit 110 and using the control unit 110 to discretize the continuous data. Optionally, the control unit 110 can be trained with a pretrained model. The training data or pretrained model may be received by the control unit 110 remotely over one or more networks. The training data may be historical data, which the neural network can use to learn patterns in the visual representations of the data to identify or detect the same (or similar) patterns in other data collected from other parts or equipment. The trained ANN monitors additional visual representations of data to identify patterns and classify the patterns. If the trained ANN detects one or more patterns, the trained ANN can classify the pattern(s) to generate classification data which can be output to a user and/or used to re-train the ANN. For example, the classification data may identify the type or mode of a potential or upcoming failure of the part or equipment.

The ANN of the control unit 110 can continue to learn to improve identification of patterns in data visualizations, as well as improve the classification of the identified patterns. This continued learning can occur by, for example, changing the output generated by one or more of the neurons responsive to receiving the same input (e.g., a neuron produces a different output after the change), changing the activation function of one or more neurons, changing one or more of the weights, and/or changing one or more of the connections between the neurons (or which neurons are connected with each other). Changing one or more of these factors can cause the ANN to produce a different output (e.g., a different pattern is identified and/or a different classification is selected) than prior to the change.

Examples of the subject disclosure provide systems and methods that allow large amounts of data to be quickly and efficiently analyzed by a computing device. For example, the control unit 110 can analyze various aspects of flights of the aircraft 102 based on the data 108 received from the sensors 106, as well as weather information for various flight paths. Further, the control unit 110 creates variables based on the various aspects, and determines flight path(s) from the variables, which can be in a format not readily discernable by a human being. As such, large amounts of data, which may not be discernable by human beings, are being tracked and analyzed. The vast amounts of data are efficiently organized and/or analyzed by the control unit 110, as described herein. The control unit 110 analyzes the data in a relatively short time in order to quickly and efficiently determine the flight path(s) for the aircraft 102. A human being would be incapable of efficiently analyzing such vast amounts of data in such a short time. As such, examples of the subject disclosure provide increased and efficient functionality, and vastly superior performance in relation to a human being analyzing the vast amounts of data.

Components of the system 100, such as the control unit 110, provide and/or enable a computer system to operate as a special computer system for determining flight paths for the aircraft 102. The control unit 110 improves upon computing devices by allowing for the determination of efficient flight paths based on tail-specific data and weather conditions, and which substantially reduces computing time and power.

Figure 5 illustrates a perspective front view of the aircraft 102, according to an example of the present disclosure. The aircraft 102 includes a propulsion system 512 that includes engines 514, for example. Optionally, the propulsion system 512 may include more engines 514 than shown. The engines 514 are carried by wings 516 of the aircraft 102. In other examples, the engines 514 may be carried by a fuselage 518 and/or an empennage 520. The empennage 520 may also support horizontal stabilizers 522 and a vertical stabilizer 524. The fuselage 518 of the aircraft 102 defines an internal cabin 530, which includes a flight deck or cockpit, one or more work sections (for example, galleys, personnel carry-on baggage areas, and the like), one or more passenger sections (for example, first class, business class, and coach sections), one or more lavatories, and/or the like. Figure 5 shows an example of an aircraft 102. It is to be understood that the aircraft 102 can be sized, shaped, and configured differently than shown in Figure 5.

Further, the disclosure comprises examples according to the following clauses:
Clause 1. A system comprising:
   an aircraft including a user interface having a display; and
   a control unit in communication with the user interface, wherein the control unit is configured to determine a flight path for a flight of the aircraft based on tail-specific data for the aircraft, and weather conditions.
Clause 2. The system of Clause 1, wherein the control unit is configured to determine the flight path before the flight of the aircraft.
Clause 3. The system of Clauses 1 or 2, wherein the control unit is configured to determine the flight path during the flight of the aircraft.
Clause 4. The system of any of Clauses 1-3, wherein the control unit is configured to determine the flight path from a machine learning model.
Clause 5. The system of Clause 4, wherein the control unit is further configured to use the machine learning model to simulate numerous possible flight paths, and determine the flight path from the numerous possible flight paths.
Clause 6. The system of Clauses 4 or 5, wherein the control unit is further configured to load and the machine learning model based on data from a current flight, current weather data, and changing aspects of a state of the aircraft.
Clause 7. The system of any of Clauses 1-6, wherein the control unit comprises an artificial neural network configured to identify the flight path.
Clause 8. The system of any of Clauses 1-7, wherein the aircraft comprises the control unit.
Clause 9. The system of any of Clauses 1-8, wherein the weather conditions comprise current weather conditions and forecasted weather conditions.
Clause 10. The system of Clauses 1-9, wherein the control unit is further configured to automatically operate the aircraft according to the flight path.
Clause 11. The system of any of Clauses 1-10, wherein the control unit is further configured to show the flight path on the display.
Clause 12. The system of any of Clauses 1-11, wherein the control unit is further configured to automatically select the flight path for the aircraft.
Clause 13. A method for a system comprising:
   an aircraft including a user interface having a display; and
   a control unit in communication with the user interface,
   the method comprising determining, by the control unit, a flight path for a flight of the aircraft based on tail-specific data for the aircraft, and weather conditions.
Clause 14. The method of Clause 13, wherein said determining comprises determining the flight path before the flight of the aircraft, and determining the flight path during the flight of the aircraft.
Clause 15. The method of Clauses 13 or 14, wherein said determining comprises using a machine learning model to determine the flight path.
Clause 16. The method of Clause 15, wherein said using comprises:
   simulating numerous possible flight paths; and
   determining the flight path from the numerous possible flight paths.
Clause 17. The method of Clauses 15 or 16, further comprising updating the machine learning model based on data from a current flight, data from past flights, current and past weather data, and changing aspects of the aircraft.
Clause 18. The method of any of Clauses 13-17, further comprising automatically operating, by the control unit, the aircraft according to the flight path.
Clause 19. The method of any of Clauses 13-18, further comprising automatically selecting, by the control unit, the flight path for the aircraft.
Clause 20. An aircraft comprising:
   controls configured to operate the aircraft;
   a user interface having a display; and
   a control unit in communication with the user interface, wherein the control unit is configured to:
      use a machine learning model to simulate numerous possible flight paths for a flight of the aircraft,
      determine a flight path for the flight from the numerous possible flight paths based on tail-specific data for the aircraft, and weather conditions,
      use the machine learning model based on data from a current flight, current weather data, and changing aspects of a state of the aircraft,
      automatically select the flight path for the aircraft, and
      show the flight path on the display.

As described herein, examples of the present disclosure provide systems and methods for efficiently and effectively assessing a flight path, including changes to an existing flight path. Further, examples of the present disclosure provide systems and methods for accurately determining an optimized flight path based on specific flight data for a particular aircraft.

While various spatial and directional terms, such as top, bottom, lower, mid, lateral, horizontal, vertical, front and the like can be used to describe examples of the present disclosure, it is understood that such terms are merely used with respect to the orientations shown in the drawings. The orientations can be inverted, rotated, or otherwise changed, such that an upper portion is a lower portion, and vice versa, horizontal becomes vertical, and the like.

As used herein, a structure, limitation, or element that is "configured to" perform a task or operation is particularly structurally formed, constructed, or adapted in a manner corresponding to the task or operation. For purposes of clarity and the avoidance of doubt, an object that is merely capable of being modified to perform the task or operation is not "configured to" perform the task or operation as used herein.

It is to be understood that the above description is intended to be illustrative, and not restrictive. For example, the above-described examples (and/or aspects thereof) can be used in combination with each other. In addition, many modifications can be made to adapt a particular situation or material to the teachings of the various examples of the disclosure without departing from their scope. While the dimensions and types of materials described herein are intended to define the aspects of the various examples of the disclosure, the examples are by no means limiting and are exemplary examples. Many other examples will be apparent to those of skill in the art upon reviewing the above description. The scope of the various examples of the disclosure should, therefore, be determined with reference to the appended claims, along with the full scope of equivalents to which such claims are entitled. In the appended claims and the detailed description herein, the terms "including" and "in which" are used as the plain-English equivalents of the respective terms "comprising" and "wherein." Moreover, the terms "first," "second," and "third," etc. are used merely as labels, and are not intended to impose numerical requirements on their objects.

This written description uses examples to disclose the various examples of the disclosure, including the best mode, and also to enable any person skilled in the art to practice the various examples of the disclosure, including making and using any devices or systems and performing any incorporated methods. The patentable scope of the various examples of the disclosure is defined by the claims, and can include other examples that occur to those skilled in the art. Such other examples are intended to be within the scope of the claims if the examples have structural elements that do not differ from the literal language of the claims, or if the examples include equivalent structural elements with insubstantial differences from the literal language of the claims.

## Claims

1. A system (100) comprising:
an aircraft (102) including a user interface (112) having a display (114); and
a control unit (110) in communication with the user interface (112), wherein the control unit (110) is configured to determine a flight path (200) for a flight of the aircraft (102) based on tail-specific data (122) for the aircraft (102), and weather conditions.

2. The system (100) of claim 1, wherein the control unit (100) is configured to determine the flight path (200) before the flight of the aircraft (102).

3. The system (100) of any one of preceding claims, wherein the control unit (110) is configured to determine the flight path (200) during the flight of the aircraft (102).

4. The system (100) of any one of preceding claims, wherein the control unit (110) is configured to determine the flight path (200) from a machine learning model.

5. The system (100) of claim 4, wherein the control unit (110) is further configured to use the machine learning model to simulate numerous possible flight paths (200), and determine the flight path (200) from the numerous possible flight paths (200).

6. The system (100) of claim 4 or claim 5, wherein the control unit (110) is further configured to load and use the machine learning model based on data (108) from a current flight, current weather data (108), and changing aspects of a state of the aircraft (102).

7. The system (100) of any one of preceding claims, wherein the control unit (110) comprises an artificial neural network configured to identify the flight path (200).

8. The system (100) of any one of preceding claims, wherein the aircraft (102) comprises the control unit (110).

9. The system (100) of any one of preceding claims, wherein the weather conditions comprise current weather conditions and forecasted weather conditions.

10. The system (100) of any one of preceding claims, wherein the control unit (110) is further configured to automatically operate the aircraft (102) according to the flight path (200).

11. The system (100) of any one of preceding claims, wherein the control unit (110) is further configured to show the flight path (200) on the display (114).

12. The system (100) of any one of preceding claims, wherein the control unit (110) is further configured to automatically select the flight path (200) for the aircraft (102).

13. A method for a system (100) comprising:
an aircraft (102) including a user interface (112) having a display (114); and
a control unit (110) in communication with the user interface (114),
the method comprising determining, by the control unit (110), a flight path (200) for a flight of the aircraft (102) based on tail-specific data (112) for the aircraft (102), and weather conditions.

14. The method of claim 13, wherein said determining comprises using a machine learning model to determine the flight path (200).

15. The method of claim 14, wherein said using comprises:
simulating numerous possible flight paths (200); and
determining the flight path (200) from the numerous possible flight paths (200).
